# EUROPÄISCHE PATENTSCHRIFT

(11) **EP 2 985 459 B1**
(45) Veröffentlichungstag und Bekanntmachung des Hinweises auf die Patenterteilung: **23.10.2019**
(21) Anmeldenummer: 15180146.1
(22) Anmeldetag: 07.08.2015
(51) Int. Cl.: F03D 17/00, F03D 80/30, F03D 80/50, F03D 80/00, G01R 1/067, G01R 31/28

(54) **UNBEMANNTES FLUGGERÄT UND VERFAHREN ZUR DURCHFÜHRUNG EINER BLITZSCHUTZMESSUNG AN EINER WINDENERGIEANLAGE**
UNMANNED AERIAL VEHICLE AND METHOD FOR PERFORMING A LIGHTNING PROTECTION MEASUREMENT ON A WIND TURBINE
AERONEF INHABITE ET PROCEDE D'EXECUTION D'UNE MESURE DE PROTECTION CONTRE LA FOUDRE SUR UNE EOLIENNE

(30) Priorität: 14.08.2014 DE 202014006541 U
(43) Veröffentlichungstag der Anmeldung: 17.02.2016
(73) Patentinhaber: Vestas Wind Systems A/S, 8200 Aarhus N (DK)
(72) Erfinder: Bruins, Marcel, 7602 BK Almelo (NL); Holling, Jochen, 48493 Wettringen (DE)
(74) Vertreter: Vestas Patents Department

(56) Entgegenhaltungen:
- CN-A- 102 879 692
- US-A- 4 904 996

## Beschreibung

Die Erfindung betrifft ein unbemanntes Fluggerät zur Durchführung einer Widerstands-, Strom- und/oder Spannungsmessung an einem Objekt, insbesondere einer Blitzschutzmessung an einer Windenergieanlage. Die Erfindung betrifft ferner ein Verfahren zur Durchführung einer Widerstands-, Strom- und/oder Spannungsmessung an einem Objekt, insbesondere einer Blitzschutzmessung an einer Windenergieanlage.

Windenergieanlagen umfassen meist einen Turm, ein auf dem Turm drehbar gelagertes Maschinenhaus, einen in dem Maschinenhaus angeordneten Triebstrang und einen den Triebstrang antreibenden Rotor mit einer Nabe und mindestens einem, meist drei drehbar an der Nabe angeordneten Rotorblättern. An der Windenergieanlage sind meist mehrere Rezeptoren zum Einleiten eines Blitzstroms verteilt. Insbesondere die Rotorblätter, gerade die Rotorblattspitzen, und/oder der Bereich des Daches des Maschinenraums weisen häufig einen solchen Rezeptor auf.

Zur Erzielung eines hohen Wirkungsgrades sind Windenergieanlagen oft in exponierten Lagen freier Gegenden aufgestellt. Deswegen und aufgrund ihrer Größe sind sie einer großen Gefahr für Blitzeinschläge ausgesetzt. Blitzableitvorrichtungen sollen sicherstellen, dass ein Blitzstrom sicher zur Erde geführt wird, ohne dass Beschädigungen oder Beeinträchtigungen der Windenergieanlage auftreten. Dazu sind die zuvor genannten Rezeptoren meist über Erdungskontakte geerdet, wozu z.B. Blitzschutzkabel und/oder Erdungskabel mit einem in das Erdreich eingelassenen Erdungskabel mit einem in das Erdreich eingelassenen Erdungsanker, der auch als Erdanschlussfahne am Turmfuß bezeichnet wird, verbunden sind.

Blitzschutzeinrichtungen von Windenergieanlagen und anderen Objekten sind regelmäßig zu warten, um deren Funktionsfähigkeit im Falle eines Blitzeinschlages sicherzustellen, wie z.B. in der DE 10 2007 027 849 A1 beschrieben. Dazu wird in der Regel ein Wartungsstrom durch ein Blitzschutzkabel zwischen Rezeptoren und Erdungskontakt geschickt und beispielsweise über einen Spannungsabfall dessen ohmscher Widerstand gemessen. Alternativ kann ein Strom durch das Blitzschutzkabel gemessen werden. Zur Durchführung einer solchen Blitzschutzmessung wird in der Regel ein Wartungskabel außen an einen Rezeptor angeklemmt. Dies wird beispielsweise durch einen sich von dem Maschinenhaus abseilenden Industriekletterer durchgeführt oder durch Wartungsmitarbeiter, die von einem Kran an einem Mannkorb herabgelassen werden. Auch von einem Kran oder dem Maschinenhaus abgelassene Arbeitsbühnen können zum Einsatz kommen. Das andere Ende des Wartungskabels wird meist mit einem im Maschinenhaus verlaufenden Abschnitt des Blitzschutzkabels oder der Erdanschlussfahne am Turmfuß verbunden, wodurch sich ein Wartungsstromkreis ausbildet, der auf Durchgang geprüft wird und über ein entsprechendes Messgerät ausgewertet wird. Verschiedene Verfahren und Vorrichtungen zur Durchführung von Blitzschutzmessungen insbesondere an Windenergieanlagen sind beispielsweise aus der DE 10 2005 017 865 B4, der DE 10 2009 059 378 A1, der DE 10 2012 009 205 A1 oder der DE 10 2012 214 981 bekannt. Die CN 102 879 692 A zeigt ein Verfahren und eine Vorrichtung zur Detektion eines Isolators durch ein unbemanntes Luftfahrzeug mit mehreren Rotoren (multi-rotor UAV).

Es besteht jedoch ein Bedarf nach verbesserten Vorrichtungen und Verfahren zur Durchführung von Widerstands-, Strom- und/oder Spannungsmessungen an Objekten, insbesondere zur Durchführung einer Blitzschutzmessung an einer Windenergieanlage, welche einfach, sicher und kostengünstig ausgeführt werden können.

Es ist daher eine Aufgabe der vorliegenden Erfindung, eine Vorrichtung und ein Verfahren zur Durchführung einer Widerstands-, Strom- und/oder Spannungsmessung an einem Objekt, insbesondere einer Blitzschutzmessung an einer Windenergieanlage, anzugeben, welche gegenüber existierenden Vorrichtungen bzw. Verfahren verbessert, insbesondere einfacher, sicher und/oder kostengünstiger ist bzw. sind.

Diese Aufgabe wird gelöst durch ein unbemanntes Fluggerät zur Durchführung einer Widerstands-, Strom- und/oder Spannungsmessung an einem Objekt, insbesondere einer Blitzschutzmessung an einer Windenergieanlage, mit einem Kontaktelement mit einer elektrisch leitfähigen Kontaktfläche, das mit einer Oberfläche des Objekts, insbesondere mit einem Blitzschutzrezeptor eines Rotorblatts, eines Maschinenhauses oder eines Turms einer Windenergieanlage, in Kontakt bringbar ist, und mit einem elektrisch leitfähigen Messkabel, das mit einem ersten Ende elektrisch leitend mit der Kontaktfläche verbunden ist und mit einem zweite Ende mit einem Widerstands-, Strom- und/oder Spannungsmessgerät und/oder einem Erdungskontakt des Objekts verbindbar ist, dadurch gekennzeichnet, dass auf der Kontaktfläche Kupferwolle angeordnet ist.

Der Erfindung liegt die Erkenntnis zugrunde, dass zur Durchführung von Widerstands-, Strom- und/oder Spannungsmessungen an einem Objekt, insbesondere einer Blitzschutzmessung an einer Windenergieanlage, in vorteilhafter Weise ein unbemanntes Fluggerät zum Einsatz kommen kann. Unter einem unbemannten Fluggerät wird hier insbesondere ein, in der Regel vom Boden aus, ferngesteuertes Luftfahrzeug verstanden, das ohne an Bord des Fluggeräts befindliche Personen betrieben und navigiert werden kann und dafür über entsprechende (Fern-) Steuereinrichtungen verfügt. Teilweise wird für solche unbemannten Fluggeräte auch der Begriff Drohne verwendet. Beispielsweise kann als unbemanntes Fluggerät ein Quadrokopter oder eine Schwebeplattform zum Einsatz kommen.

Der Einsatz unbemannter Fluggeräte zu Wartungszwecken ist grundsätzlich bekannt, beispielsweise aus der WO 2013/060693 A2, DE 10 2005 023 796 A1 oder der US 4,818,990. Auch im Bereich der Windenergieanlagen werden unbemannte Fluggeräte zu Wartungszwecken eingesetzt, beispielsweise in der WO 2010/051278 A1, der DE 10 2008 053 928 A1, der DE 10 2010 048 400 A1 oder der DE 10 2011 118 833 B3. All diesen existierenden Wartungsvorrichtungen und Verfahren mittels unbemannter Flugobjekte ist jedoch gemein, dass sie keinen Kontakt zwischen dem unbemannten Fluggerät und dem Objekt bzw. der Windenergieanlage herstellen, sondern lediglich das unbemannte Fluggerät in die Nähe des Objekts bzw. der Windenergieanlage gebracht wird, um über Bilderfassung oder berührungslose Messungen Informationen über den Zustand der Windenergieanlage zu gewinnen.

Da für eine Blitzschutzmessung jedoch die Herstellung eines Messstromkreises erforderlich ist, sind die existierenden Vorrichtungen und Verfahren zur Wartung von Objekten bzw. Windenergieanlagen durch unbemannte Fluggeräte für die Durchführung einer Blitzschutzmessung grundsätzlich nicht geeignet. Vielmehr ist es bei den existierenden Verfahren und Vorrichtungen gerade erforderlich, jeglichen Kontakt zwischen dem unbemannten Fluggerät und einem Objekt oder einer Windenergieanlage zu vermeiden. Die Erfindung beruht demgegenüber auf der Erkenntnis, einen Kontakt zwischen dem Fluggerät und dem Objekt bzw. der Windenergieanlage herzustellen und auf diese Weise die Bildung eines Messstromkreises zu ermöglichen.

Das erfindungsgemäße unbemannte Fluggerät weist hierzu ein Kontaktelement auf, das, vorzugsweise durch kontrollierte Flugbewegungen des Fluggeräts, mit einer Oberfläche des Objekts in Kontakt gebracht wird. Das Kontaktelement weist dazu eine elektrisch leitfähige Kontaktfläche auf. Diese Kontaktfläche des Kontaktelements wird bei einer Blitzschutzmessung einer Windenergieanlage vorzugsweise mit einem Blitzschutzrezeptor, der in einer Rotorblattspitze, am Dach eines Maschinenhauses oder im Turm einer Windenergieanlage angeordnet sein kann, in Berührung gebracht. Mit dieser elektrisch leitfähigen Kontaktfläche ist ein elektrisch leitfähiges Messkabel elektrisch leitend verbunden. Ein anderes Ende dieses Messkabels dient der Herstellung eines Messstromkreises und kann dazu mit einem Erdungskontakt oder einem Blitzschutzkabel des Objekts und/oder einem Widerstands-, Strom- und/oder Spannungsmessgerät verbunden werden. Das Messkabel ist vorzugsweise ausreichend lang ausgebildet, um von der vorgesehenen Flughöhe und Distanz des Fluggeräts aus bis zu einem Punkt am Boden zu reichen.

Auf diese Weise ermöglicht es das erfindungsgemäße unbemannte Fluggerät, eine in der Regel unzugängliche oder schwer zugängliche Oberfläche des Objekts, wie beispielsweise ein Rotorblatt einer Windenergieanlage, durch die Verbindung über die Kontaktfläche und das Messkabel in einen Messstromkreis einzubinden, in dem dann über eine Widerstands-, Strom- und/oder Spannungsmessung eine Blitzschutzmessung durchgeführt werden kann. Neben der Verbindung eines ersten Endes des elektrisch leitfähigen Messkabels mit der elektrisch leitfähigen Kontaktfläche ist dann das zweite Ende des Messkabels mit dem Messgerät zu verbinden und/oder mit einem Erdungskontakt des Objekts, was beispielsweise eine Erdanschlussfahne am Turmfuß, oder auch ein Teil der Blitzschutzleitung in der Windenergieanlage sein kann, wie beispielsweise das Potenzialausgleichssystem im Maschinenhaus oder eine Funkenstrecke, wenn die Ableitung zum Maschinenhaus über eine Funkenstrecke realisiert ist. Durch ein solches Schließen eines Messstromkreises unter Zuhilfenahme des mit der Kontaktfläche elektrisch leitend verbundenen Messkabels wird durch den Einsatz des erfindungsgemäßen unbemannten Fluggeräts eine Widerstands-, Strom- und/oder Spannungsmessung möglich, ohne dass eine Person eine elektrisch leitende Verbindung zwischen dem Messkabel und dem Blitzschutzrezeptor vor Ort am Blitzschutzrezeptor herstellen muss.

Die Verbindung des Messkabels mit der Kontaktfläche ist vorzugsweise lösbar, ebenso wie die Verbindung des Messkabels mit dem Widerstands-, Strom- und/oder Spannungsmessgerät und/oder dem Erdungskontakt des Objekts. Das Messkabel ist vorzugsweise bis zu 100 m lang oder länger und kann beispielsweise auf einer Trommel bereitgestellt werden, sodass die Trommel mit dem zweiten Ende des Messkabels am Boden verbleibt und beim Abheben des Fluggeräts vom Boden das Messkabel entsprechend von der Trommel abgewickelt wird.

Zur Durchführung der Messung wird der Kontakt zwischen dem Kontaktelement und der Oberfläche des Objekts vorzugsweise für eine vorbestimmte Messdauer gehalten, insbesondere für mindestens 2 s, mindestens 5 s, mindestens 10 s oder mindestens 20 s. Vorzugsweise ist das unbemannte Fluggerät ausgebildet, zumindest für die Zeit der Messdauer im Schwebeflug zu fliegen, d.h. in einem Flugzustand, bei dem das Fluggerät in unveränderter Position und unveränderter Höhe in der Luft verbleibt.

Es kann auch vorgesehen sein, dass das Fluggerät ferner ein mit dem zweiten Ende des Messkabels verbundenes Widerstands-, Strom- und/oder Spannungsmessgerät umfasst. In dieser Variante befindet sich das Widerstands-, Strom- und/oder Spannungsmessgerät ebenfalls am Fluggerät und kann vorzugsweise ebenfalls ferngesteuert werden. In der Regel wird jedoch das Widerstands-, Strom- und/oder Spannungsmessgerät am Boden verbleiben und von dort aus bedient werden.

In einer bevorzugten Ausführungsform ist vorgesehen, dass an dem Fluggerät eine Bilderfassungseinrichtung, vorzugsweise eine Digital- oder CCD-Kamera, angeordnet ist. Die Bilderfassungseinrichtung überträgt Daten vorzugsweise kabellos an eine Auswertungs- und/oder Ausgabeeinheit am Boden und kann ferner vorzugsweise ebenfalls vom Boden aus ferngesteuert werden. Die Bilderfassungseinrichtung am Fluggerät dient u.a. zur Navigation und insbesondere zur Identifikation der zur kontaktierenden Oberfläche am Objekt, insbesondere zur Identifikation der Rezeptoren.

Dabei ist es insbesondere bevorzugt, dass die Bilderfassungseinrichtung derart angeordnet und ausgebildet ist, dass sie das Kontaktelement und vorzugsweise seine unmittelbare Umgebung, insbesondere einen Bereich zwischen der Kontaktfläche und dem Objekt erfasst. Die Bilderfassungseinrichtung erweist sich insbesondere dann als vorteilhaft, wenn sie das Kontaktelement und seine unmittelbare Umgebung, wie beispielsweise einen Bereich von mindestens 2 m, vorzugsweise 5 m oder 10 m um die Kontaktfläche herum erfassen kann und insbesondere bei Annäherung des Fluggeräts an die Oberfläche des zu kontaktierenden Objekts diese zu kontaktierende Oberfläche des Objekts miterfasst.

In einer weiteren bevorzugten Ausführungsform ist vorgesehen, dass mindestens ein Flugantrieb des Fluggeräts mit einem ersten Ende eines elektrischen Leiters verbunden ist und ein zweites Ende des elektrischen Leiters mit einem Stromanschluss verbindbar ist. Das Vorsehen eines solchen elektrischen Leiters, der vorzugsweise lösbar mit dem Flugantrieb verbindbar ist und ebenfalls lösbar mit einem Stromanschluss verbindbar ist, ist es, dass die Laufzeit und/oder die Leistung des mindestens einen Flugantriebs des Fluggeräts deutlich erhöht werden kann, wenn der Flugantrieb nicht (nur) aus einer auf dem Fluggerät mitgeführten mobilen Energieversorgung gespeist werden muss, sondern über den elektrischen Leiter an die Energieversorgung eines Stromnetzes angeschlossen werden kann.

Besonders bevorzugt ist, dass die Verbindung des ersten Endes des Messkabels mit der Kontaktfläche und/oder die Verbindung des zweiten Endes des Messkabels mit dem Widerstands-, Strom- und/oder Spannungsmessgerät bzw. dem Erdungskontakt des Objekts und/oder die Verbindung des ersten Endes des elektrischen Leiters mit dem mindestens einen Flugantrieb und/oder die Verbindung des zweiten Endes des elektrischen Leiters mit dem Stromanschluss lösbar ausgebildet ist bzw. sind. Eine solche lösbare Verbindung hat zum einen den Vorteil, dass die Verbindungen wahlweise hergestellt und getrennt werden können und ferner beispielsweise im Falle einer drohenden Gefahr oder einer Behinderung des freien Laufs des Messkabels und/oder elektrischen Leiters schnell getrennt werden können.

Besonders bevorzugt ist ferner, dass die Verbindung des ersten Endes des Messkabels mit der Kontaktfläche und/oder die Verbindung des zweiten Endes des Messkabels mit dem Widerstands-, Strom- und/oder Spannungsmessgerät bzw. dem Erdungskontakt des Objekts und/oder die Verbindung des ersten Endes des elektrischen Leiters mit dem mindestens einen Flugantrieb und/oder die Verbindung des zweiten Endes des elektrischen Leiters mit dem Stromanschluss derart ausgebildet ist bzw. sind, dass die Verbindung(en) gelöst wird bzw. werden, wenn eine vorbestimmte, auf das Messkabel und/oder den elektrischen Leiter wirkende Zugkraft überschritten wird. Hierbei ist eine Art Sicherheitsverbindung vorgesehen, die sich automatisch bzw. selbsttätig löst, wenn eine bestimmte Zugkraft auf das Messkabel und/oder den elektrischen Leiter wirkt. Dies kann beispielsweise auftreten, wenn sich das Messkabel und/oder der elektrische Leiter in einem Hindernis verfangen oder anderweitig blockiert werden und das Fluggerät seinen Flug bzw. Aufstieg fortsetzt und dadurch eine Zugkraft auf das Messkabel und/oder den elektrischen Leiter ausübt. Die Zugkraft, ab der die Verbindung(en) gelöst wird bzw. werden, ist vorzugsweise abgestimmt auf eine übliche Auftriebs- bzw. Vortriebskraft des Fluggeräts.

Erfindungsgemäße Ausgestaltungen des Kontaktelements sehen vor, dass auf der Kontaktfläche Kupferwolle angeordnet ist, was die Herstellung einer elektrisch leitenden Verbindung zwischen einem Blitzschutzrezeptor und der Kontaktfläche erleichtert. Ferner ist die Kontaktfläche vorzugsweise im Wesentlichen vertikal ausgerichtet und/oder konkav ausgebildet. Eine solche Ausbildung kann vorteilhaft sein, um einen Kontakt zu vertikal ausgerichteten, konvex ausgebildeten Flächen, wie beispielsweise dem Turm einer Windenergieanlage, herzustellen. Das Kontaktelement ist vorzugsweise das Element des Fluggeräts, welches sich, insbesondere in einer horizontalen Richtung, am weitesten entfernt von einem Schwerpunkt und/oder einem geometrischen Mittelpunkt des Fluggeräts befindet.

In einer weiteren bevorzugten Ausgestaltung ist vorgesehen, dass das Kontaktelement über ein Verbindungselement, das vorzugsweise im Wesentlichen stangenförmig ausgebildet ist, mit dem Fluggerät verbunden ist, wobei das Verbindungselement vorzugsweise im Wesentlichen horizontal ausgerichtet ist. Das Verbindungselement kann beispielsweise auch als fachwerkartige Struktur ausgebildet sein.

Das Messkabel und/oder der elektrische Leiter kann bzw. können vorteilhafterweise im Verbindungselement geführt sein.

Ferner ist bevorzugt, dass die Kontaktfläche und/oder das Kontaktelement gefedert, beweglich und/oder lösbar an dem Fluggerät und/oder an dem Verbindungselement befestigt ist bzw. sind. Die Kontaktfläche und/oder das Kontaktelement können direkt am Fluggerät oder indirekt, beispielsweise über das Verbindungselement, am Fluggerät befestigt sein. Eine lösbare Befestigung ist beispielsweise bevorzugt, um die Kontaktfläche und/oder das Kontaktelement austauschen oder warten zu können. Eine bewegliche Befestigung, vorzugsweise eine Befestigung, die zwischen einer beweglichen und einer unbeweglichen Position verändert werden kann, kann bevorzugt sein, um die zu kontaktierende Oberfläche des Objekts noch besser erreichen zu können. Beispielsweise kann ein Mechanismus bevorzugt sein, bei dem das Fluggerät in einer Position im Schwebeflug gehalten wird, bei der sich die Kontaktfläche bereits kurz vor der zu kontaktierenden Oberfläche des Objekts befindet und das Kontaktelement mit der Kontaktfläche dann beispielsweise über eine teleskopartige Verlängerung des Verbindungselements auf das Objekt zubewegt wird, um den Kontakt herzustellen. Ferner ist eine gefederte Befestigung der Kontaktfläche und/oder des Kontaktelements bevorzugt, um Beschädigungen an der Kontaktfläche, dem Kontaktelement, dem Fluggerät und/oder dem Objekt zu vermeiden.

Ferner ist eine Ausgestaltung bevorzugt, in der das Verbindungselement gefedert, beweglich und/oder lösbar an dem Fluggerät befestigt ist. Auch das Verbindungselement kann direkt am Fluggerät oder indirekt über andere Zwischenelemente am Fluggerät befestigt sein. Das Verbindungselement kann beispielsweise auch als teleskopartig verlängerbare Stange ausgebildet sein und ein Federelement oder einen Stoßdämpfer zur federnden Befestigung aufweisen. Die Vorteile einer gefederten, beweglichen und/oder lösbaren Befestigung am Fluggerät sind für das Verbindungselement ähnlich wie für die Kontaktfläche bzw. das Kontaktelement.

Eine weitere bevorzugte Ausgestaltung ergibt sich insbesondere dadurch, dass die Bilderfassungseinrichtung derart angeordnet und ausgebildet ist, dass sie das Kontaktelement in einer Blickrichtung im Wesentlichen in Richtung des Verbindungselements oder parallel dazu erfasst. Diese Ausgestaltung hat den Vorteil, dass über die Bilderfassungseinrichtung die Annäherung des Kontaktelements an die zu kontaktierende Oberfläche des Objekts gut erfasst werden kann und damit einem das Fluggerät über die Fernsteuerung steuernden Piloten die Navigation des Fluggeräts zur Kontaktierung der zu kontaktierenden Oberfläche des Objekts mittels der Kontaktfläche erleichtert werden kann.

Gemäß einem weiteren Aspekt der Erfindung wird die eingangs genannte Aufgabe gelöst durch ein Verfahren zur Durchführung einer Widerstands-, Strom- und/oder Spannungsmessung an einem Objekt, insbesondere einer Blitzschutzmessung an einer Windenergieanlage, umfassend Bereitstellen eines unbemannten Fluggeräts nach mindestens einem der vorhergehenden Ansprüche, Verbinden des zweiten Endes des Messkabels mit einem Widerstands-, Strom- und/oder Spannungsmessgerät und/oder einem Erdungskontakt des Objekts, Kontaktieren einer Oberfläche des Objekts, insbesondere eines Blitzschutzrezeptors eines Rotorblatts, eines Maschinenhauses oder eines Turms einer Windenergieanlage, mit der Kontaktfläche des Kontaktelements durch kontrollierte Flugbewegungen des Fluggeräts, Halten des Kontakts zwischen der Kontaktfläche des Kontaktelements und der Oberfläche des Objekts für eine vorbestimmte Messdauer, vorzugsweise durch einen Schwebeflug des Fluggeräts, Messen eines Widerstands, eines Stroms und/oder einer Spannung, vorzugsweise mittels des Widerstands-, Strom- und/oder Spannungsmessgeräts.

Die Widerstands-, Strom- und/oder Spannungsmessung erfolgt vorzugsweise im Stromkreis zwischen dem Blitzschutzrezeptor und einer Erdanschlussfahne am Turmfuß mittels des Widerstands-, Strom- und/oder Spannungsmessgeräts. Das erfindungsgemäße Verfahren und seine möglichen Fortbildungen weisen Merkmale bzw. Verfahrensschritte auf, die sie insbesondere dafür geeignet machen, mit einem erfindungsgemäßen Fluggerät und seinen Fortbildungen verwendet zu werden.

Zu den Vorteilen, Ausführungsvarianten und Ausführungsdetails des erfindungsgemäßen Verfahrens und seiner Fortbildungen wird daher auf die vorangegangene Beschreibung zu den entsprechenden Merkmalen des Fluggeräts verwiesen.

Eine bevorzugte Ausführungsform der Erfindung wird beispielhaft anhand der beiliegenden Figuren beschrieben. Es zeigen:
- Fig. 1:: eine beispielhafte Ausführungsform eines unbemannten Fluggeräts gemäß der Erfindung;
- Fig. 2:: das Fluggerät gemäß Fig. 1 im Einsatz beim Kontaktieren des Turms einer Windenergieanlage;
- Fig. 3:: einen vergrößerten Ausschnitt aus Fig. 1;
- Fig. 4:: einen Blick auf eine Anzeigeeinrichtung der Kamera des Fluggeräts gemäß Fig. 1;
- Fig. 5:: das Fluggerät gemäß Fig. 1 im Einsatz beim Kontaktieren eines Rezeptors an einer Rotorblattspitze einer Windenergieanlage;
- Fig. 6:: das Display einer Anzeigeeinrichtung der Kamera des Fluggeräts bei der Kontaktierung des Rezeptors an der Rotorblattspitze wie in Fig. 5 gezeigt; und

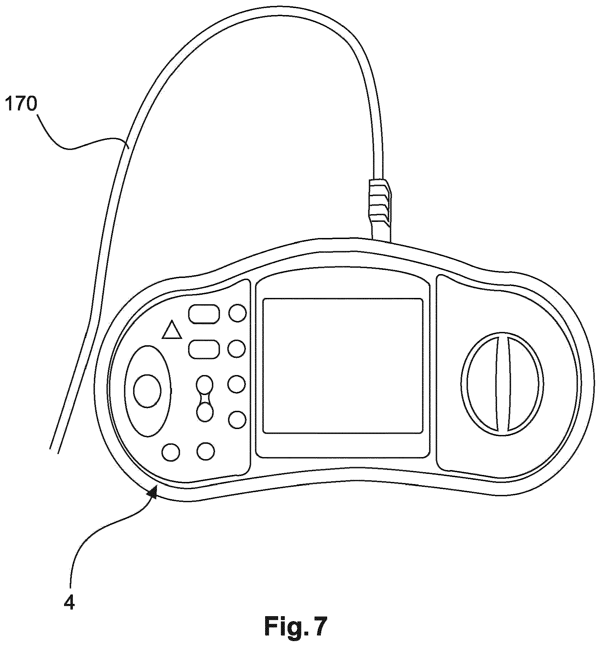

- Fig. 7:: ein Widerstands-, Strom- und/oder Spannungsmessgerät zum Einsatz mit dem Fluggerät gemäß Fig. 1.

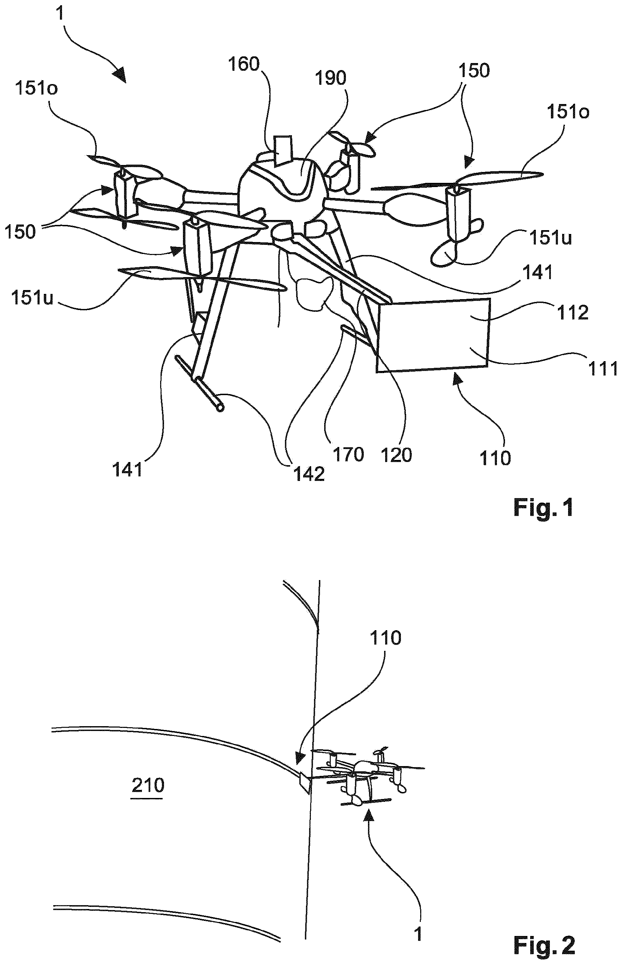

In den Figuren 1 bis 3 und 5 ist ein beispielhaftes unbemanntes Fluggerät 1 gemäß der Erfindung dargestellt.

Das Fluggerät 1 weist ein Kontaktelement 110 mit einer elektrisch leitfähigen Kontaktfläche 111 auf, auf der Kupferwolle 112 angeordnet ist. Die Kontaktfläche 111 ist im Wesentlichen vertikal ausgerichtet und über ein stab- bzw. stangenförmig ausgebildetes Verbindungselement, das im Wesentlichen horizontal ausgerichtet ist, an dem Fluggerät 1, insbesondere dem zentralen Hauptkörper 140, befestigt.

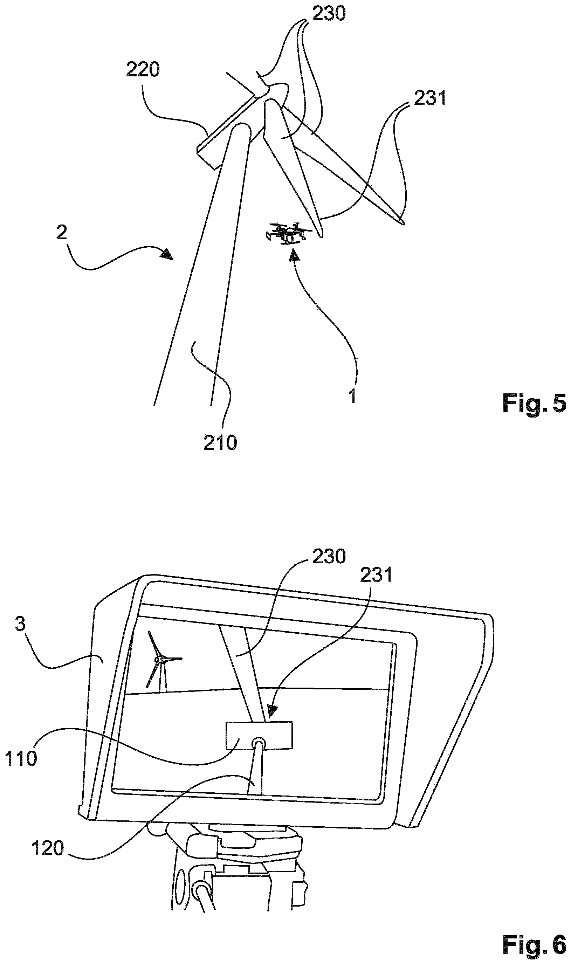

Von einem zentralen Hauptkörper 140 des Fluggeräts 1 gehen zwei Beine 141 ab, die am unteren Ende Standfüße 142 aufweisen, auf denen das Fluggerät 1 am Boden stehen kann. Vom zentralen Hauptkörper 140 gehen ferner vier Arme 150 ab, an denen jeweils obere und untere Rotoren 151o,u angeordnet sind. Das Fluggerät 1 ist damit quadrokopterartig ausgebildet und kann neben einem Steig- und Senkflug sowie Vorwärtsbewegungen auch im Schwebeflug gehalten werden, wie beispielsweise in den Figuren 2 und 5 zu erkennen ist. Auf diese Weise kann das Fluggerät 1 verschiedene Teile eines Objekts, wie beispielsweise einer Windenergieanlage 2, anfliegen und sich zu kontaktierende Oberflächen, wie beispielsweise Blitzschutzrezeptoren an verschiedenen Stellen, wie beispielsweise den Spitzen 231 der Rotorblätter 230, dem Maschinenhaus 220 oder dem Turm 210 einer Windenergieanlage 2, zu nähern.

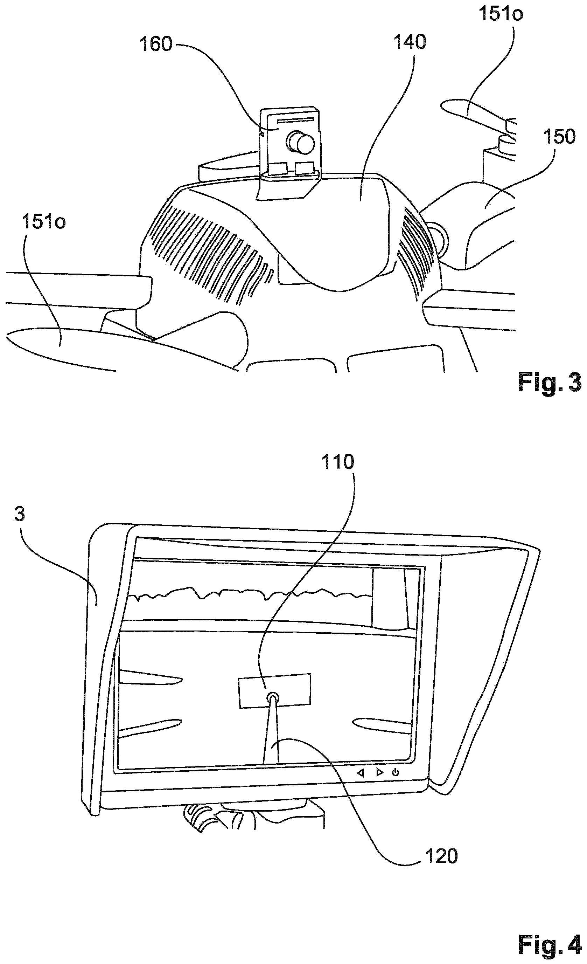

Zur Unterstützung der Navigation ist am Hauptkörper 140 eine Bilderfassungseinrichtung 160 in Form einer CCD-Kamera angeordnet. Wie insbesondere in den Figuren 4 und 6 zu erkennen ist, ist die Kamera kabellos mit einer am Boden befindlichen Anzeigeeinrichtung 3 verbunden und so angeordnet, dass sie das Kontaktelement 110 und seine unmittelbare Umgebung, insbesondere auch einen Bereich zwischen der Kontaktfläche 110 und dem Objekt, hier der Windenergieanlage 2, erfasst. Die Kamera 160 ist ferner so angeordnet und ausgebildet, dass sie das Kontaktelement 110 in einer Blickrichtung im Wesentlichen in Richtung des Verbindungselements 120 bzw. parallel dazu erfasst, wie ebenfalls in den Figuren 4 und 6 zu erkennen ist.

Das Kontaktelement 110 mit der mit Kupferwolle 112 versehenen Kontaktfläche 111 ist elektrisch leitend mit dem elektrisch leitfähigen Messkabel 170 verbunden. Ein zweites Ende dieses Messkabels 170 verbleibt während des Fluges des Fluggeräts 1 am Boden. Das Messkabel 170 kann beispielsweise während des Fluges des Fluggeräts 1 von einer Trommel (nicht dargestellt) abgerollt werden.

Zur Durchführung der Blitzschutzmessung wird das zweite Ende des Messkabels 170 mit einem Widerstands-, Strom- und/oder Spannungsmessgerät 4 und/oder einem Erdungskontakt des Objekts, insbesondere der Erdanschlussfahne am Turmfuß einer Windenergieanlage 2, verbunden. Insgesamt ist ein Messstromkreis herzustellen, der das Blitzschutzkabel der Windenergieanlage vom Rezeptor bis zum Erdungskontakt oder zumindest einen zu überprüfenden Teil davon umfasst und in den das Widerstands-, Strom- und/oder Spannungsmessgerät 4 über das Messkabel 170 eingebunden ist.

Auf diese Weise kann darauf verzichtet werden, dass die Verbindung zwischen einem Messkabel und dem Blitzschutzrezeptor durch Wartungspersonal hergestellt wird, das dazu vom Maschinengehäuse abgeseilt werden muss oder über eine Arbeitsbühne zu den jeweiligen Blitzschutzrezeptoren gebracht werden muss. Durch den Einsatz des erfindungsgemäßen Fluggeräts kann das Personal am Boden verbleiben, was deutlich einfacher, sicherer und weniger zeit- und kostenaufwändig ist.

### BEZUGSZEICHEN

- 1: Fluggerät
- 110: Kontaktelement
- 111: Kontaktfläche
- 112: Kupferwolle
- 120: Verbindungselement
- 140: Hauptkörper
- 141: Beine
- 142: Standfuß
- 150,: Arme
- 151o, 151u: Rotoren
- 160: Bilderfassungseinrichtung
- 170: Messkabel
- 2: Windenergieanlage
- 210: Turm
- 220: Maschinenhaus
- 230: Rotorblatt
- 231: Spitzen
- 3: Anzeigeeinrichtung
- 4: Widerstands-, Strom- und/oder Spannungsmessgerät

## Patentansprüche

1. Unbemanntes Fluggerät (1) zur Durchführung einer Widerstands-, Strom- und/oder Spannungsmessung an einem Objekt, insbesondere einer Blitzschutzmessung an einer Windenergieanlage (2),
mit einem Kontaktelement (110) mit einer elektrisch leitfähigen Kontaktfläche (111), das mit einer Oberfläche des Objekts, insbesondere mit einem Blitzschutzrezeptor eines Rotorblatts (230), eines Maschinenhauses (220) oder eines Turms (210) einer Windenergieanlage (2), in Kontakt bringbar ist, und mit einem elektrisch leitfähigen Messkabel (170), das mit einem ersten Ende elektrisch leitend mit der Kontaktfläche (111) verbunden ist und mit einem zweiten Ende mit einem Widerstands-, Strom- und/oder Spannungsmessgerät (4) und/oder einem Erdungskontakt des Objekts verbindbar ist,
**dadurch gekennzeichnet, dass** auf der Kontaktfläche (111) Kupferwolle (112) angeordnet ist.

2. Fluggerät (1) Anspruch 1,
**dadurch gekennzeichnet, dass** das Kontaktelement (110) über ein Verbindungselement (120), das vorzugsweise im wesentlichen stangenförmig ausgebildet ist, mit dem Fluggerät (1) verbunden ist, wobei das Verbindungselement (120) vorzugsweise im wesentlichen horizontal ausgerichtet ist.

3. Fluggerät (1) nach Anspruch 2,
**dadurch gekennzeichnet, dass** die Kontaktfläche (111) und/oder das Kontaktelement (110) gefedert, beweglich und/oder lösbar an dem Verbindungselement (120) befestigt ist bzw. sind.

4. Fluggerät (1) nach einem der Ansprüche 2 oder 3,
**dadurch gekennzeichnet, dass** das Verbindungselement (120) gefedert, beweglich und/oder lösbar an dem Fluggerät (1) befestigt ist.

5. Fluggerät (1) nach mindestens einem der Anspruch 2, 3 oder 4,
**dadurch gekennzeichnet, dass** das Messkabel (170) im Verbindungselement (120) geführt ist.

6. Fluggerät (1) nach Anspruch 1,
**dadurch gekennzeichnet, dass** an dem Fluggerät (1) eine Bilderfassungseinrichtung (160), vorzugsweise eine Digital- oder CCD-Kamera, angeordnet ist.

7. Fluggerät (1) nach Anspruch 6,
**dadurch gekennzeichnet, dass** die Bilderfassungseinrichtung (160) derart angeordnet und ausgebildet ist, dass sie das Kontaktelement (110) und vorzugsweise seine unmittelbare Umgebung, insbesondere einen Bereich zwischen der Kontaktfläche (111) und dem Objekt erfasst.

8. Fluggerät (1) nach Anspruch 6 oder 7,
**dadurch gekennzeichnet, dass** die Bilderfassungseinrichtung (160) derart angeordnet und ausgebildet ist, dass sie das Kontaktelement (110) in einer Blickrichtung (160) im wesentlichen in Richtung eines Verbindungselements (120), mit dem das Kontaktelement (110) mit dem Fluggerät (1) verbunden ist, oder parallel dazu erfasst.

9. Fluggerät (1) nach mindestens einem der vorhergehenden Ansprüche,
**dadurch gekennzeichnet, dass** das Fluggerät (1) ferner das mit dem zweiten Ende des Messkabels (170) verbindbare Widerstands-, Strom- und/oder Spannungsmessgerät (4) umfasst, wobei das Widerstands-, Strom- und/oder Spannungsmessgerät (4) durch eine Verbindung mit dem zweiten Ende des Messkabels (170) verbunden ist.

10. Fluggerät (1) nach Anspruch 9,
**dadurch gekennzeichnet, dass** mindestens ein Flugantrieb des Fluggeräts (1) mit einem ersten Ende eines elektrischen Leiters verbunden ist und ein zweites Ende des elektrischen Leiters mit einem Stromanschluss verbunden ist.

11. Fluggerät (1) nach Anspruch 10,
**dadurch gekennzeichnet, dass** die Verbindung des ersten Endes des Messkabels (170) mit der Kontaktfläche (111) und/oder die Verbindung des zweiten Endes des Messkabels (170) mit dem Widerstands-, Strom- und/oder Spannungsmessgerät (4) und/oder die Verbindung des ersten Endes des elektrischen Leiters mit dem mindestens einen Flugantrieb und/oder die Verbindung des zweiten Endes des elektrischen Leiters mit dem Stromanschluss lösbar ausgebildet ist bzw. sind.

12. Fluggerät (1) nach Anspruch 10,
**dadurch gekennzeichnet, dass** die Verbindung des ersten Endes des Messkabels (170) mit der Kontaktfläche und/oder die Verbindung des zweiten Endes des Messkabels (170) mit dem Widerstands-, Strom- und/oder Spannungsmessgerät (4) und/oder die Verbindung des ersten Endes des elektrischen Leiters mit dem mindestens einen Flugantrieb und/oder die Verbindung des zweiten Endes des elektrischen Leiters mit dem Stromanschluss derart ausgebildet ist bzw. sind, dass die Verbindung(en) gelöst wird bzw. werden, wenn eine vorbestimmte, auf das Messkabel (170) und/oder den elektrischen Leiter wirkende Zugkraft überschritten wird.

13. Fluggerät (1) nach mindestens einem der vorhergehenden Ansprüche,
**dadurch gekennzeichnet, dass** die Kontaktfläche (111) im wesentlichen vertikal ausgerichtet und/oder konkav ausgebildet ist.

14. Fluggerät (1) nach mindestens einem der vorhergehenden Ansprüche,
**dadurch gekennzeichnet, dass** die Kontaktfläche (111) und/oder das Kontaktelement (110) gefedert, beweglich und/oder lösbar an dem Fluggerät (1) befestigt ist bzw. sind.

15. Verfahren zur Durchführung einer Widerstands-, Strom- und/oder Spannungsmessung an einem Objekt, insbesondere einer Blitzschutzmessung an einer Windenergieanlage (2), umfassend
Bereitstellen eines unbemannten Fluggeräts (1) nach mindestens einem der vorhergehenden Ansprüche,
Verbinden des zweiten Endes des Messkabels (170) mit dem Widerstands-, Strom- und/oder Spannungsmessgerät (4) und/oder dem Erdungskontakt des Objekts,
Kontaktieren einer Oberfläche des Objekts, insbesondere eines Blitzschutzrezeptors eines Rotorblatts (230), eines Maschinenhauses (220) oder eines Turms (210) einer Windenergieanlage (2), mit der Kontaktfläche des Kontaktelements (110) durch kontrollierte Flugbewegungen des Fluggeräts (1),
Halten des Kontakts zwischen der Kontaktfläche (111) des Kontaktelements (110) und der Oberfläche des Objekts für eine vorbestimmte Messdauer, vorzugsweise durch einen Schwebeflug des Fluggeräts (1),
Messen eines Widerstands, eines Stroms und/oder einer Spannung.

## Claims

1. Unmanned aerial device (1) for performing a resistance, current and/or voltage measurement on an object, in particular a lightning protection measurement on a wind turbine (2),
having a contact element (110) with an electrically conductive contact surface (111), which can be brought into contact with a surface of the object, in particular with a lightning protection receptor of a rotor blade (230), a nacelle (220) or a tower (210) of a wind turbine (2), and having an electrically conductive measurement cable (170), which with a first end is connected in an electrically conductive manner to the contact surface (111) and with a second end can be connected to a resistance, current and/or voltage measuring device (4) and/or a grounding contact of the object,
**characterised in that** copper wool (112) is arranged on the contact surface (111).

2. Aerial device (1) according to claim 1,
**characterised in that** the contact element (110) is connected to the aerial device (1) by a connecting element (120), which is preferably designed to be essentially rod-like, wherein the connecting element (120) is preferably aligned to be essentially horizontal.

3. Aerial device (1) according to claim 2,
**characterised in that** the contact surface (111) and/or the contact element (110) is or are attached respectively to the connecting element (120) in a spring-mounted, movable and/or detachable manner.

4. Aerial device (1) according to any of claims 2 or 3,
**characterised in that** the connecting element (120) is attached to the aerial device (1) in a spring-mounted, movable and/or detachable manner.

5. Aerial device (1) according to at least one of claims 2, 3 or 4,
**characterised in that** the measurement cable (170) is guided in the connecting element (120).

6. Aerial device (1) according to claim 1,
**characterised in that** an image capturing system (160), preferably a digital or CCD camera, is arranged on the aerial device (1).

7. Aerial device (1) according to claim 6,
**characterised in that** the image capturing system (160) is arranged and designed such that it captures the contact element (110) and preferably its immediate environment, in particular an surface between the contact surface (111) and the object.

8. Aerial device (1) according to claim 6 or 7,
**characterised in that** the image capturing system (160) is arranged and designed such that it captures the contact element (110) in a viewing direction (160) essentially in the direction of a connecting element (120), by which the contact element (110) is connected to the aerial device (1), or parallel to the latter.

9. Aerial device (1) according to at least one of the preceding claims,
**characterised in that** the aerial device (1) also comprises the resistance, current and/or voltage measuring device (4) connectable to the second end of the measurement cable (170), wherein the resistance, current and/or voltage measuring device (4) is connected by a connection to the second end of the measurement cable (170).

10. Aerial device (1) according to claim 9,
**characterised in that** at least one flight propulsion unit of the aerial device (1) is connected to a first end of an electric conductor and a second end of the electric conductor is connected to a power supply connection.

11. Aerial device (1) according to claim 10,
**characterised in that** the connection between the first end of the measurement cable (170) and the contact surface (111) and/or the connection between the second end of the measurement cable (170) and the resistance, current and/or voltage measuring device (4) and/or the connection between the first end of the electrical conductor and the at least one flight propulsion unit and/or the connection between the second end of the electrical conductor and the power supply connection is or are designed respectively in a detachable manner.

12. Aerial device (1) according to claim 10,
**characterised in that** the connection between the first end of the measurement cable (170) and the contact surface and/or the connection between the second end of the measurement cable (170) and the resistance, current and/or voltage measuring device (4) and/or the connection between the first end of the electrical conductor and the at least one flight propulsion unit and/or the connection between the second end of the electrical conductor and the power supply connection is or are designed respectively in such a way that the connection(s) will be severed if a predetermined tensile force on the measurement cable (170) and/or the electrical conductor is exceeded.

13. Aerial device (1) according to at least one of the preceding claims,
**characterised in that** the contact surface (111) is aligned to be essentially vertical and/or is designed to be concave.

14. Aerial device (1) according to at least one of the preceding claims,
**characterised in that** the contact surface (111) and/or the contact element (110) is or are attached respectively to the aerial device (1) in a spring-mounted, movable and/or detachable manner.

15. Method for performing a resistance, current and/or voltage measurement on an object, in particular a lightning protection measurement, on a wind turbine (2), comprising
providing an unmanned aerial device (1) according to at least one of the preceding claims,
connecting the second end of the measurement cable (170) to the resistance, current and/or voltage measuring device (4) and/or the grounding contact of the object,
contacting a surface of the object, in particular a lightning protection receptor of a rotor blade (230), a nacelle (220) or a tower (210) of a wind turbine (2), with the contact surface of the contact element (110) by means of controlled flying movements of the aerial device (1),
maintaining the contact between the contact surface (111) of the contact element (110) and the surface of the object for a predetermined measurement duration, preferably by hovering the aerial device (1),
measuring a resistance, a current and/or a voltage.

## Revendications

1. Aéronef inhabité (1) pour la réalisation d'une mesure de résistance, courant et/ou tension au niveau d'un objet, en particulier une mesure de protection contre la foudre au niveau d'une éolienne (2),
avec un élément de contact (110) avec une surface de contact (111) électroconductrice qui peut être amené en contact avec une surface de l'objet, en particulier avec un récepteur de protection contre la foudre d'une pale de rotor (230), d'une nacelle (220) ou d'une tour (210) d'une éolienne (2), et avec un câble de mesure (170) électroconducteur qui est raccordé à une première extrémité de manière électroconductrice à la surface de contact (111) et peut être raccordé à une seconde extrémité à un dispositif de mesure de résistance, courant et/ou tension (4) et/ou un contact de mise à la terre de l'objet,
**caractérisé en ce que** de la laine de cuivre (112) est agencée sur la surface de contact (111).

2. Aéronef (1) selon la revendication 1,
**caractérisé en ce que** l'élément de contact (110) est raccordé à l'aéronef (1) par le biais d'un élément de raccordement (120) qui est réalisé de préférence sensiblement en forme de tige, dans lequel l'élément de raccordement (120) est de préférence orienté sensiblement horizontalement.

3. Aéronef (1) selon la revendication 2,
**caractérisé en ce que** la surface de contact (111) et/ou l'élément de contact (110) est ou sont fixés sur ressort, de manière mobile et/ou détachable au niveau de l'élément de raccordement (120).

4. Aéronef (1) selon l'une quelconque des revendications 2 ou 3,
**caractérisé en ce que** l'élément de raccordement (120) est fixé sur ressort, de manière mobile et/ou détachable au niveau de l'aéronef (1).

5. Aéronef (1) selon au moins l'une quelconque des revendications 2, 3 ou 4,
**caractérisé en ce que** le câble de mesure (170) est guidé dans l'élément de raccordement (120).

6. Aéronef (1) selon la revendication 1,
**caractérisé en ce qu'**un système de détection d'image (160), de préférence une caméra numérique ou CCD, est agencé au niveau de l'aéronef (1).

7. Aéronef (1) selon la revendication 6,
**caractérisé en ce que** le système de détection d'image (160) est agencé et réalisé de telle manière qu'il détecte l'élément de contact (110) et de préférence son environnement immédiat, en particulier une zone entre la surface de contact (111) et l'objet.

8. Aéronef (1) selon la revendication 6 ou 7,
**caractérisé en ce que** le système de détection d'image (160) est agencé et réalisé de telle manière qu'il détecte l'élément de contact (110) dans un sens d'observation (160) sensiblement en direction d'un élément de raccordement (120) avec lequel l'élément de contact (110) est raccordé à l'aéronef (1), ou parallèlement à celui-ci.

9. Aéronef (1) selon au moins l'une quelconque des revendications précédentes,
**caractérisé en ce que** l'aéronef (1) comporte de plus le dispositif de mesure de résistance, courant et/ou tension (4) raccordable à la seconde extrémité du câble de mesure (170), dans lequel le dispositif de mesure de résistance, courant et/ou tension (4) est raccordé par un raccordement à la seconde extrémité du câble de mesure (170).

10. Aéronef (1) selon la revendication 9,
**caractérisé en ce qu'**au moins un entraînement de vol de l'aéronef (1) est raccordé à une première extrémité d'un conducteur électrique et une seconde extrémité du conducteur électrique est raccordée à un raccord de courant.

11. Aéronef (1) selon la revendication 10,
**caractérisé en ce que** le raccordement de la première extrémité du câble de mesure (170) avec la surface de contact (111) et/ou le raccordement de la seconde extrémité du câble de mesure (170) avec le dispositif de mesure de résistance, courant et/ou tension (4) et/ou le raccordement de la première extrémité du conducteur électrique avec l'au moins un entraînement de vol et/ou le raccordement de la seconde extrémité du conducteur électrique avec le raccord de courant est ou sont réalisés de manière détachable.

12. Aéronef (1) selon la revendication 10,
**caractérisé en ce que** le raccordement de la première extrémité du câble de mesure (170) avec la surface de contact et/ou le raccordement de la seconde extrémité du câble de mesure (170) avec le dispositif de mesure de résistance, courant et/ou tension (4) et/ou le raccordement de la première extrémité du conducteur électrique avec l'au moins un entraînement de vol et/ou le raccordement de la seconde extrémité du conducteur électrique avec le raccord de courant est ou sont réalisés de telle manière que le(s) raccordement(s) soit ou soient détachés si une force de traction prédéterminée agissant sur le câble de mesure (170) et/ou le conducteur électrique est dépassée.

13. Aéronef (1) selon au moins l'une quelconque des revendications précédentes,
**caractérisé en ce que** la surface de contact (111) est orientée sensiblement verticalement et/ou est réalisée de manière concave.

14. Aéronef (1) selon au moins l'une quelconque des revendications précédentes,
**caractérisé en ce que** la surface de contact (111) et/ou l'élément de contact (110) est ou sont fixés sur ressort, de manière mobile et/ou détachable au niveau de l'aéronef (1).

15. Procédé de réalisation d'une mesure de résistance, courant et/ou tension au niveau d'un objet, en particulier une mesure de protection contre la foudre au niveau d'une éolienne (2), comprenant
la mise à disposition d'un aéronef inhabité (1) selon au moins l'une quelconque des revendications précédentes,
le raccordement de la seconde extrémité du câble de mesure (170) avec le dispositif de mesure de résistance, courant et/ou tension (4) et/ou le contact de mise à la terre de l'objet,
la mise en contact d'une surface de l'objet, en particulier d'un récepteur de protection contre la foudre d'une pale de rotor (230), d'une nacelle (220) ou d'une tour (210) d'une éolienne (2), avec la surface de contact de l'élément de contact (110) par des mouvements de vol contrôlés de l'aéronef (1),
le maintien du contact entre la surface de contact (111) de l'élément de contact (110) et la surface de l'objet pour une durée de mesure prédéterminée, de préférence par un vol stationnaire de l'aéronef (1),
la mesure d'une résistance, d'un courant et/ou d'une tension.
